# FASCICULE DE BREVET EUROPEEN

(11) **EP 3 098 965 B1**
(45) Date de publication et mention de la délivrance du brevet: **18.11.2020**
(21) Numéro de dépôt: 16171342.5
(22) Date de dépôt: 25.05.2016
(51) Int. Cl.: H03K 17/972, G06F 3/02, H01H 11/00, H01H 19/08

(54) **BOUTON DE COMMANDE UNIVERSEL À EFFET HALL POUR INTERFACE HOMME-MACHINE ET INTERFACE HOMME-MACHINE DOTÉE DE TEL BOUTON DE COMMANDE**
UNIVERSALSTEUERKNOPF MIT HALL-EFFEKT FÜR MENSCH-MASCHINE-SCHNITTSTELLE, UND MIT EINEM SOLCHEN STEUERKNOPF AUSGESTATTETE MENSCH-MASCHINE-SCHNITTSTELLE
UNIVERSAL CONTROL BUTTON WITH HALL EFFECT FOR HUMAN-MACHINE INTERFACE, AND HUMAN-MACHINE INTERFACE PROVIDED WITH SUCH A CONTROL BUTTON

(30) Priorité: 27.05.2015 FR 1554733
(43) Date de publication de la demande: 30.11.2016
(73) Titulaire: Zodiac Aero Electric, 93100 Montreuil (FR)
(72) Inventeur: SIMAO, Antonio, 92390 Villeneuve La Garenne (FR)
(74) Mandataire: Casalonga

(56) Documents cités:
- EP-A1- 2 814 048
- EP-A2- 2 781 993
- US-A- 4 354 077
- US-A1- 2008 238 650

## Description

La présente invention se rapporte, de manière générale, aux interfaces homme-machine, notamment pour aéronefs, et concerne plus particulièrement un bouton de commande à effet Hall pour interface homme-machine à panneau numérique pour cockpit d'aéronef.

Les panneaux de commande de cockpit d'aéronef sont en effet dotés d'un certain nombre de boutons de commande qui sont manipulables manuellement par les pilotes pour l'exécution d'une ou de plusieurs fonctions d'avionique. Il s'agit généralement de boutons de commande électro-mécaniques, par exemple des boutons-poussoirs intégrant des interrupteurs ou des boutons rotatifs à potentiomètre ou tout autre dispositif de commande par rotation d'un bouton (interrupteur rotatif, encodeur, ...).

Comme on le conçoit, le nombre et l'encombrement des boutons de commande imposent des contraintes qui doivent être prises en compte par les fabricants de panneaux de commande.

En outre, dans l'état de la technique, les boutons de commande assurent une commutation de puissance et font par conséquent partie du circuit d'alimentation des organes dont ils assurent la commande.

En fonction de la nature des éléments pilotés, un panneau de commande peut être doté de boutons rotatifs, pouvant comprendre plusieurs positions angulaires prédéterminées de sélection ou à rotation lisse, ou encore de boutons-poussoirs. Il est donc nécessaire de prévoir divers types de boutons rotatifs ou de boutons-poussoirs qui doivent être fixés à demeure sur le panneau de commande selon une configuration requise. Ainsi, il n'est généralement pas possible de remplacer un type de bouton, par exemple un bouton poussoir, par un autre type de bouton, par exemple rotatif pour, par exemple, s'adapter à un cahier des charges imposant une configuration spécifique du panneau de commande.

Un exemple de bouton de commande universel pour interface homme-machine, est divulgué dans le document EP 2 781 993 A2. Ledit bouton de commande comprend un socle incluant des moyens de détection de champ magnétique et une pluralité d'organes modulaires comprenant chacun un aimant dont l'actionnement est détecté par les moyens de détection de champ magnétique du socle. Au vu de ce qui précède, l'invention propose un bouton de commande universel pour interface homme-machine qui puisse venir se monter de manière interchangeable sur une telle interface.

Un autre but de l'invention est de fournir un tel bouton de commande qui présente une fiabilité accrue et ce, dans un encombrement réduit.

L'invention a donc pour objet un bouton de commande universel à effet Hall pour interface homme-machine, comprenant un socle destiné à venir se monter sur l'interface et un ensemble de modules interchangeables manipulables manuellement venant chacun se monter sur le socle et comprenant chacun un aimant bipolaire, le socle étant pourvu de moyens de détection du champ magnétique émis par l'aimant.

Ainsi, grâce aux modules de commande interchangeables qui viennent se monter sur un socle universel, on peut configurer un panneau de commande à partir de composants génériques venant sélectivement se monter sur l'interface. En outre, l'utilisation d'un bouton de commande à effet Hall permet d'améliorer considérablement la fiabilité.

Dans un mode de réalisation, les moyens de détection sont adaptés pour détecter un déplacement en rotation et/ou en translation de l'aimant.

Le module de commande comporte des moyens d'éclairage et une carte d'éclairage pilotant les moyens d'éclairage à partir de signaux d'éclairage provenant de l'interface.

En d'autres termes, le bouton assure en outre une fonction de signalisation permettant, notamment, d'identifier aisément la position du bouton ou de fournir des informations additionnelles au pilote.

Le module de commande comporte un ensemble d'au moins une patte s'emboîtant chacune dans un logement pratiqué dans le socle pour la fixation mécanique et le raccordement électrique du module de commande, la patte et le logement étant dotés de contacts complémentaires pour la transmission de signaux d'éclairage et d'alimentation.

On notera que l'ensemble de modules de commande comporte un module de commande à rotation lisse, un module de commande rotatif comprenant un encodage de positions de commande ou un module de commande à bouton poussoir. Dans le cas de boutons de commande rotatif, on utilisera avantageusement des boutons de commande actionnables en tiré-poussé.

On prévoira avantageusement que le socle et les modules sont dotés de circuits de détection et de commande redondants et séparés.

Dans ce cas, on pourra prévoir que les circuits de détection et de commande sont reliés par un bus de communication.

L'invention a également pour objet, selon un second aspect, une interface homme-machine comprenant un ensemble de boutons tel que défini ci-dessus.

D'autres buts, caractéristiques et avantages de l'invention apparaîtront à la lecture de la description suivante, donnée uniquement à titre d'exemple non limitatif, et faite en référence aux dessins annexés sur lesquels :
- la figure 1 est une vue en perspective de côté d'un premier exemple de réalisation d'un bouton de commande conforme à l'invention ;
- la figure 2 illustre une autre configuration du bouton de commande selon la figure 1 ; et
- la figure 3 illustre l'assemblage d'un bouton de commande selon l'invention.

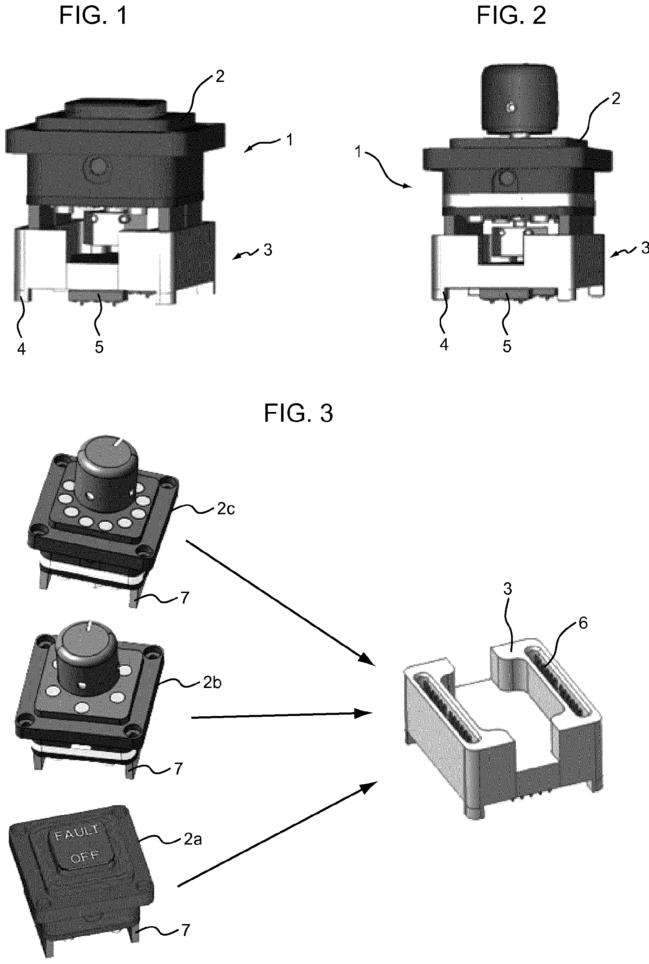

On a représenté sur les figures 1 à 3 un bouton de commande conforme à l'invention, désigné par la référence numérique générale 1.

Ce bouton de commande est destiné à être monté dans un panneau numérique d'une interface homme-machine de cockpit d'aéronef et à être manipulé manuellement par le pilote pour l'exécution d'une ou de plusieurs fonctions d'avionique.

Comme indiqué précédemment, il s'agit d'un bouton de commande universel à effet Hall, qui comporte un module de commande 2 et un socle 3 universel.

Le socle 3 est destiné à venir se fixer sur un panneau numérique de commande du cockpit de l'aéronef et comporte à cet effet un ensemble de pieds, tels que 4, et des broches 5 destinées à être raccordées à des broches complémentaires prévues sur le panneau pour la transmission, vers le panneau numérique, de signaux de commande générés lors de la manipulation du module de commande 2 et la transmission, vers ce dernier, de signaux d'alimentation ou de signaux de contrôle du module de commande 2.

Comme on le voit sur la figure 3, le socle universel 3 comporte un corps comprenant un ensemble de logements 6, ici au nombre de deux, réalisés sous la forme de fentes dans lesquelles s'emboîtent par complémentarité de forme des pattes 7 prévues sur le module de commande.

Comme on le voit, les logements 6 sont dotés d'un certain nombre de contacts destinés à coopérer avec des contacts correspondants prévus sur les pattes 7 pour la transmission des signaux de commande fournis par le module de commande au panneau numérique et les signaux d'alimentation et de contrôle du module de commande.

Comme illustré sur la figure 3, le bouton de commande est assemblé à partir de plusieurs modules de commandes interchangeables qui viennent sélectivement se monter sur un socle 3 universel capable de recevoir différents types d'organes de commande. Le module de commande utilisé est choisi en fonction du type de fonction commandé et de la nature des ordres de commande.

Il peut s'agir d'un bouton de commande de type bouton poussoir 2a, d'un bouton rotatif procurant un encodage de position à plusieurs positions prédéterminées. Il peut par exemple s'agir d'un bouton rotatif 2b fournissant un encodage à six positions ou un bouton rotatif 2c fournissant un encodage à 12 positions. Bien entendu, le nombre de positions prédéterminées n'est nullement limitatif. Il serait également possible de prévoir un encodage à 32 positions.

Selon un autre mode de mise en œuvre non représenté, le bouton rotatif peut encore être un bouton poussoir à rotation lisse.

Toutefois, dans les divers modes de mise en œuvre des boutons rotatifs, on prévoira avantageusement un mode supplémentaire d'actionnement en tiré et poussé afin, le cas échéant, de pouvoir remplacer un bouton poussoir.

Dans tous les cas, les modules de commande viennent se monter par emboîtement sur le support universel 3 pour constituer un bouton de commande à effet Hall.

Les modules de commande incorporent à cet effet un aimant bipolaire dont la position est commandée lors de la manipulation du bouton tandis que le socle comporte des moyens de détection du champ magnétique émis par l'aimant bipolaire. Il s'agit en l'espèce de capteurs à effet Hall qui assurent la mesure du champ magnétique émis par l'aimant bipolaire intégré au module de commande.

Bien entendu, le capteur à effet Hall est adapté pour détecter aussi bien un mouvement de translation qu'un mouvement de rotation de l'aimant bipolaire de manière à être capable d'assurer la détection d'une modification du champ magnétique aussi bien lors de la rotation d'un module de commande à bouton rotatif que lors de la translation d'un module de commande à bouton poussoir ou à bouton rotatif intégrant une commande en tiré et en poussé.

Par ailleurs, les modules de commande sont dotés de moyens d'éclairage pour fournir au pilote des informations concernant l'état de la fonction commandée ou pour signaler la zone à manipuler.

Il peut par exemple s'agir d'un liséré lumineux entourant la zone à manipuler ou d'un ou de plusieurs points lumineux indiquant la position du module de commande. Il peut également s'agir de moyens d'éclairage en forme de bague lumineuse ou de voyant lumineux sur les boutons-poussoirs.

Dans ces divers modes de mise en œuvre, on utilisera avantageusement un affichage à plusieurs couleurs. On utilisera de préférence des diodes électroluminescentes multicolores (RGB) pour assurer cette fonction d'éclairage, qui présentent l'avantage de pouvoir recréer n'importe quelle couleur par synthèse additive des composantes de rouge, de vert et de bleu.

Chaque module de commande est ainsi doté d'une carte d'éclairage, identique pour tous les boutons, pilotée par le socle universel 3 à partir d'ordres d'activation des moyens d'éclairage provenant du panneau numérique.

On notera enfin que, afin d'améliorer la fiabilité des boutons de commande, on prévoira avantageusement que les circuits de détection, notamment les détecteurs à effet Hall intégrés au socle ainsi que les circuits de commande qui assurent la commande des modules de commande sont redondants et séparés.

On pourra à cet égard prévoir que le socle 3 comporte deux capteurs à effet Hall, deux bus séparés de communication avec les modules de commande, notamment incorporés aux logements 6, deux cartes d'éclairage pour, par exemple, assurer l'éclairage par moitié des moyens d'éclairage, deux circuits d'alimentation et deux microcontrôleurs de contrôle des modules de commande.

On prévoira avantageusement un bus de synchronisation entre ces circuits de détection et de commande redondants et séparés afin de maintenir un comportement complet du bouton de commande même lorsqu'un dysfonctionnement apparaît au sein de l'un de ces circuits de détection et de commande, par exemple au sein de l'un des bus de communication.

Comme on le conçoit, l'invention qui vient d'être décrite, qui utilise un socle universel ainsi qu'un ensemble de modules de commande permet de réaliser l'ensemble des boutons de commande qui sont traditionnellement montés sur un panneau d'un cockpit d'aéronef grâce à l'utilisation d'un socle universel qui est capable d'assurer de manière générique une détection de la manipulation de tout type de module de commande pour retransmettre les actions de rotation, de poussé ou de tiré au contrôleur du panneau de commande.

On notera qu'à la différence des composants de cockpit utilisés traditionnellement dans l'état de la technique, le bouton de commande qui vient d'être décrit n'assure aucune fonction de commutation de puissance du courant de commande mais assure une détection de la position du module de commande qui est retransmise au contrôleur du panneau de commande. En d'autres termes, le bouton de commande n'est destiné qu'à émettre des informations traduisant la position du module de commande et à recevoir des signaux de contrôle et d'alimentation, la fonction de commutation de puissance étant mise en œuvre par le contrôleur du panneau de commande.

En outre, la fonction de commande ne met en œuvre aucun élément mécanique puisque la détection de la position du module de commande s'effectue grâce au capteur à effet Hall intégré au socle.

Il a été constaté qu'un tel bouton de commande permet d'assurer une commande avec une précision accrue dans la mesure où les signaux de commande issus du bouton de commande sont des signaux numériques et non analogiques, et ce, dans un encombrement réduit. Un tel bouton de commande présente une fiabilité accrue, obtenue grâce à la suppression de la mobilité de pièces électroniques.

Par ailleurs, un tel bouton de commande, qui est contrôlé à partir de signaux numériques et qui fournit des signaux de commande numériques, est capable de s'intégrer parfaitement dans un panneau numérique de commande d'un cockpit d'aéronef et ce, avec une fiabilité accrue et un encombrement réduit.

Enfin, dans les divers modes de réalisation décrits, on obtient une diminution de la hauteur du bouton de commande, permettant d'obtenir une diminution consécutive de l'épaisseur du panneau de commande dans lequel il vient se monter. Il a à cet égard été constaté que la diminution de la hauteur pouvait atteindre voire dépasser 30%.

## Revendications

1. Bouton de commande à effet Hall pour interface homme-machine, comportant un socle (3) destiné à venir se monter sur l'interface et un module de commande comportant des moyens d'éclairage et une carte d'éclairage pilotant les moyens d'éclairage à partir de signaux d'éclairage provenant de l'interface,
le module de commande étant choisi parmi un ensemble de modules de commande (2) interchangeables,
le module de commande comportant un ensemble d'au moins une patte (7) s'emboîtant chacune dans un logement (6) pratiqué dans le socle pour la fixation mécanique et le raccordement électrique du module de commande, la patte et le logement étant dotés de contacts complémentaires pour la transmission de signaux d'éclairage et d'alimentation,
le module de commande étant manipulable manuellement, venant se monter sur le socle et comprenant un aimant bipolaire,
le socle étant pourvu de moyens de détection du champ magnétique émis par l'aimant.

2. Bouton selon la revendication 1, dans lequel les moyens de détection sont adaptés pour détecter un déplacement en rotation et/ou en translation de l'aimant.

3. Bouton de commande selon l'une quelconque des revendications 1 à 2, dans lequel l'ensemble de modules de commande comporte un module de commande rotatif à rotation lisse.

4. Bouton de commande selon l'une quelconque des revendications 1 à 2, dans lequel l'ensemble de modules de commande comporte un module de commande rotatif comprenant un encodage de positions du module.

5. Bouton de commande selon la revendication 3 ou 4, dans lequel le module de commande rotatif est actionnable en tiré-poussé.

6. Bouton de commande selon l'une quelconque des revendications 1 à 5, dans lequel l'ensemble de modules de commande comporte un module de commande à bouton poussoir.

7. Bouton de commande selon l'une quelconque des revendications 1 à 6, dans lequel le socle et les modules de commande sont dotés de circuits de détection et de commande redondants et séparés,
le socle étant pourvu de circuits de détection comprenant les moyens de détection du champ magnétique émis par l'aimant,
le socle étant muni par ailleurs de circuits de commande configurés pour commander le module de commande.

8. Bouton de commande selon la revendication 7, dans lequel les circuits de détection et de commande sont reliés par un bus de communication.

9. Interface homme-machine comprenant un ensemble de boutons de commande selon l'une quelconque des revendications 1 à 8.

## Patentansprüche

1. Steuerknopf mit Hall-Effekt für Mensch-Maschine-Schnittstelle, einen Sockel (3) beinhaltend, der dazu bestimmt ist, an der Schnittstelle montiert zu werden, und ein Steuermodul, das Beleuchtungsmittel und eine Beleuchtungskarte beinhaltet, die die Beleuchtungsmittel ausgehend von Beleuchtungssignalen, die von der Schnittstelle kommen, ansteuert,
wobei das Steuermodul aus einer Einheit von untereinander austauschbaren Steuermodulen (2) ausgewählt wird,
wobei das Steuermodul eine Einheit aus mindestens einer Lasche (7) beinhaltet, die jeweils in eine Aufnahme (6) einrastet, die zur mechanischen Befestigung und den elektrischen Anschluss des Steuermoduls in den Sockel eingearbeitet ist, wobei die Lasche und die Aufnahme mit ergänzenden Kontakten für die Übertragung von Beleuchtungs- und Versorgungssignalen versehen sind,
wobei das Steuermodul von Hand manipulierbar ist, auf dem Sockel montiert ist, und einen bipolaren Magneten umfasst,
wobei der Sockel mit Mitteln zum Erkennen des vom Magneten ausgegebenen Magnetfelds versehen ist.

2. Knopf nach Anspruch 1, wobei die Erkennungsmittel ausgeführt sind, um eine Dreh- und/oder Translationsbewegung des Magneten zu erkennen.

3. Steuerknopf nach einem der Ansprüche 1 bis 2, wobei die Einheit der Steuermodule ein drehbares Steuermodul mit gleichmäßig laufender Drehung beinhaltet.

4. Steuerknopf nach einem der Ansprüche 1 bis 2, wobei die Einheit der Steuermodule ein drehbares Steuermodul beinhaltet, das eine Positionscodierung des Moduls umfasst.

5. Steuerknopf nach Anspruch 3 oder 4, wobei das drehbare Steuermodul durch Drücken und Ziehen betätigbar ist.

6. Steuerknopf nach einem der Ansprüche 1 bis 5, wobei die Einheit der Steuermodule ein Steuermodul mit Druckknopf beinhaltet.

7. Steuerknopf nach einem der Ansprüche 1 bis 6, wobei der Sockel und die Steuermodule mit redundanten und getrennten Erkennungs- und Steuerschaltungen versehen sind,
wobei der Sockel mit Erkennungsschaltungen besetzt ist, die die Mittel zum Erkennen des vom Magneten ausgegebenen Magnetfelds umfassen,
wobei der Sockel weiter mit Steuerschaltungen ausgestattet ist, die konfiguriert sind, um das Steuermodul zu steuern.

8. Steuerknopf nach Anspruch 7, wobei die Erkennungs- und Steuerschaltungen durch einen Kommunikationsbus verbunden sind.

9. Mensch-Maschine-Schnittstelle, eine Einheit von Steuerknöpfen nach einem der Ansprüche 1 bis 8 umfassend.

## Claims

1. Hall-effect control button for a man-machine interface, **characterized in that** it comprises a base (3) which is designed for mounting on the interface, and a control module comprising lighting means (9) and a lighting board (10) for the control of the lighting means on the basis of lighting signals originating from the interface,
the control module being chosen among a series of interchangeable control modules (2),
the control module comprise a combination of at least one lug (7), which engages respectively with a socket (6) provided in the base for the mechanical attachment and electrical connection of the control module, wherein the lug and the socket are provided with complementary contacts (8a, 8b) for the transmission of lighting and power supply signals,
the control module being manually actuable mounted on the base and comprising a bipolar magnet (M),
the base being provided with means for the detection of the magnetic field emitted by the magnet.

2. Button according to Claim 1, wherein the detection means are designed to detect a rotational and/or translational motion of the magnet.

3. Control button according to one of Claims 1 to 2, wherein the series of control modules comprises a continuous-rotation rotary control module.

4. Control button according to one of Claims 1 to 2, wherein the series of control modules comprises a rotary control module with a module position encoding function.

5. Control button according to Claim 3 or 4, wherein the rotary control module can be actuated by a pull-push function.

6. Control button according to one of Claims 1 to 5, wherein the series of control modules comprises a push-button control module.

7. Control button according to one of Claims 1 to 6, wherein the base and the control modules are provided with redundant and separate detection and control circuits,
the base being provided with means for the detection of the magnetic field emitted by the magnet,
the base further comprising control circuits configured for controlling the control modules.

8. Control button according to Claim 7, wherein the detection and control circuits are linked by a communication bus.

9. Man-machine interface comprising a series of control buttons according to one of Claims 1 to 8.
